# DEMANDE DE BREVET EUROPEEN

(11) **EP 1 081 814 A1**
(43) Date de publication de la demande: **07.03.2001**
(21) Numéro de dépôt: 00402397.4
(22) Date de dépôt: 30.08.2000
(51) Int. Cl.: H01S 5/026

(54) **Composant electro-optique multi-sections**

(30) Priorité: 31.08.1999 FR 9910957
(71) Demandeur: ALCATEL, 75008 Paris (FR)
(72) Inventeur: Mallecot, Franck, 94230 Cachan (FR); Chaumont, Christine, 94230 Cachan (FR); Leroy, Arnaud, 94230 Cachan (FR); Plais, Antonina, 94230 Cachan (FR)
(74) Mandataire: Ballot, Paul

(57) **Abrégé**

L' invention concerne un composant électro-optique en semi-conducteur comprenant au moins deux structures optiquement actives (20, 30) dont au moins une est constituée par un détecteur (30), caractérisé en ce que le(s) détecteur(s) (30) comprend(nent) une première portion active (33) apte à détecter un signal à une longueur d'onde donnée et une deuxième portion inactive (34) faiblement sensible au signal à détecter et exposée à la lumière parasite non guidée véhiculée dans le composant.

## Description

La présente invention se rapporte à un composant électro-optique en semi-conducteur comprenant au moins deux sections optiquement actives ayant chacune un guide d'onde enterré dans une couche de gaine. Pour ce type de composant électro-optique multi-sections, il est important d'avoir une isolation électrique élevée entre chaque section afin d'éviter des interactions entre celles-ci au cours du fonctionnement du composant. L'invention se rapporte plus particulièrement à tout composant électro-optique, comprenant au moins un élément récepteur intégré avec un autre élément.

L'objectif de la présente invention est de permettre un fonctionnement simultané des structures optiquement actives sans aucune interaction entre l'émetteur et le récepteur et/ou entre les différents récepteurs détectant des signaux à différentes longueurs d'onde.

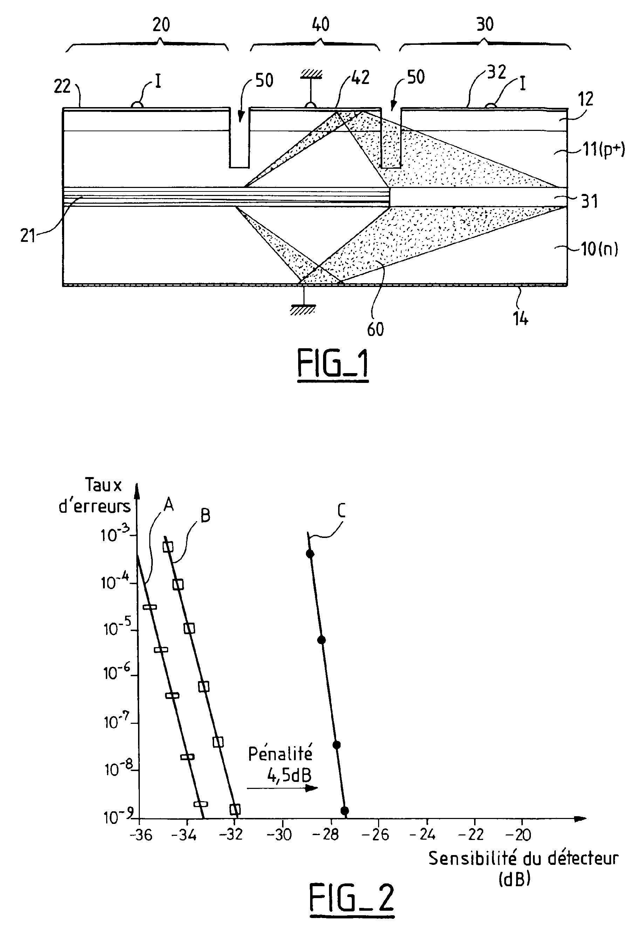

La figure 1 représente un schéma en coupe longitudinale d'un composant émetteur-récepteur en ligne classique, noté 1D-TRD ("In-line Transmitter Receiver Device" en littérature anglo-saxonne), obtenu par intégration monolithique d'un laser 20 et d'un détecteur 30 sur un même substrat 10. Le laser 20 émet un signal vers une fibre optique par exemple, tandis que le détecteur 30 reçoit un signal en provenance de cette même fibre optique. La longueur d'onde d'émission du laser 20 est inférieure à la longueur d'onde de réception du détecteur 30. Par exemple, la longueur d'onde d'émission est égale à 1,3 µm tandis que la longueur d'onde de réception est égale à 1,55 µm. Dans ce cas, étant donné que la longueur d'onde d'émission est inférieure à la longueur d'onde de réception, et que le laser 20 est situé à proximité du détecteur 30, le laser peut amener des perturbations optiques sur le détecteur. En effet, le laser émet aussi, en direction du détecteur, de la lumière à 1,3 µm qui vient éblouir ce dernier.

Pour éviter cet éblouissement du détecteur, le composant comporte une troisième section, disposée entre le laser 20 et le détecteur 30, formant un isolant optique 40. Cet isolant optique permet d'absorber la lumière émise à 1,3 µm en direction du détecteur, de manière à ce que ce dernier puisse détecter le signal optique à 1,55 µm en provenance de la fibre optique sans être perturbé par le laser.

Le substrat 10, ou couche inférieure, peut par exemple être de l'InP dopé n. Les guides d'ondes, respectivement 31 du détecteur 30 et 21 du laser 20 et de l'isolant optique 40, sont gravés sous forme de rubans et enterrés dans une couche de gaine 11 fortement dopée. Les guides d'onde sont dits de type BRS ("Buried Ridge Structure" en littérature anglo-saxonne). Le matériau de gaine 11 est dopé p+ lorsque le substrat est dopé n. Bien sûr, ce type de ruban n'est qu'un exemple. D'autres types de rubans peuvent convenir. Les dopages n et p des différentes couches peuvent en outre être inversés.

La composition et les dimensions des guides d'onde importent peu. Dans l'exemple de la figure 1, le guide d'onde 31 du détecteur 30 est par exemple réalisé en matériau ternaire, alors que le guide d'onde 21 du laser 20 et de l'isolant optique 40 est réalisé dans une structure à puits quantiques.

D'autre part, des électrodes métalliques 22, 32, 42 et 14 sont formées sur les différentes sections et sur le dessous du composant, de manière à permettre son fonctionnement.

Une couche absorbante 12 dopée par le même type de porteurs que la couche de gaine 11 se situe entre la couche conductrice 11 et les électrodes métalliques 22, 32, 42 de manière à permettre un bon contact électrique et afin de recueillir les porteurs qui permettent de détecter le signal sur l'électrode 32 du détecteur 30. Cette couche absorbante 12 peut être constituée en matériau ternaire par exemple.

Du fait de la présence de couches conductrices 11, le composant comporte en outre des zones d'isolation électrique 50, ou zones de résistivité, entre les différentes sections 20, 30, 40 afin d'éviter toute perturbation électrique d'une section vis à vis d'une autre lors du fonctionnement du composant.

Ce type d'émetteur-récepteur en ligne, comportant une partie centrale 40 permettant d'absorber tout le flux de lumière émis à 1,3 µm vers le détecteur, fonctionne très bien pour toute la lumière qui est guidée dans les rubans de guides d'onde 21.

Cependant, la totalité de la lumière émise n'est pas entièrement guidée. En effet, il existe aussi de la lumière spontanée qui est émise dans tout le volume du composant. De plus, une partie de la lumière stimulée peut aussi être diffractée dans le composant du fait de la présence de défauts dans le guide d'onde 21.

Les courbes de la figure 2 mettent en évidence les pénalités constatées sur la sensibilité du détecteur, en dB, pour différents modes de fonctionnement. La courbe A représente une référence en réception lorsque le laser est éteint, la courbe B représente une référence en réception lorsque le laser est allumé en continu et la courbe C représente le fonctionnement simultané du laser et du détecteur. On constate une pénalité de 4,5 dB entre la courbe B et la courbe C, lorsque l'on module simultanément le laser et le détecteur. Cette pénalité est en outre accrue par l'augmentation de la puissance du laser.

Cette pénalité est principalement optique. Elle est causée par la lumière non guidée émise à 1,3µm, dans toutes les directions, qui vient perturber le détecteur à 1,55µm.

Cette perturbation optique est représentée très schématiquement sur la figure 1 par l'onde 60. L'électrode métallique 14, disposée à l'interface substrat-air, peut jouer un rôle de réflecteur optique dans le substrat 10. Une partie de la lumière spontanée émise dans le volume du composant peut donc être réfléchie par l'électrode 14 et revenir se coupler au guide d'onde 31 du détecteur 30 par dessous. De même, une partie de la lumière parasite 60 peut également être réfléchie sur les électrodes 42 et 32 car la couche absorbante 12 n'absorbe pas toute cette lumière parasite 60.

Bien sûr, la perturbation du détecteur 30 par la lumière non guidée 60 est en réalité bien plus complexe qu'une simple réflexion. En effet, une partie de la lumière parasite peut en outre subir de multiples réflexions dans la couche inférieure 10 et dans la couche supérieure 11. Une autre partie de cette lumière parasite peut également venir éblouir le détecteur en incidence rasante par exemple.

Des techniques ont déjà été envisagées pour combattre la pénalité de 4,5 dB constatée dans l'exemple donné figure 2, qui se produit lors du fonctionnement simultané du laser et du détecteur. Les techniques envisagées sont essentiellement des techniques électroniques.

Ces techniques consistent par exemple, à prélever une partie du signal de modulation laser, puis à le soustraire en réception. L'utilisation de ces techniques de traitement électronique a démontré une réduction de 2 dB de la pénalité. Cependant elles nécessitent la mise au point, la fabrication et le développement d'une électronique spécifique pour ce type de composant émetteur-récepteur particulier, si bien qu'elles augmentent considérablement le coût de ce composant. Or, on recherche à fabriquer ce type de composant à grande échelle et donc à réduire au maximum son prix de revient. Par conséquent, ces techniques de traitement électronique ne peuvent pas être mises en oeuvre pour la fabrication en masse d'un tel composant.

De plus, un émetteur-récepteur en ligne est destiné à être installé chez des abonnés et il doit pouvoir fonctionner entre environ 0 et 70 °C sans aucune régulation en température. Or, la fiabilité de ces techniques électroniques n'a pas été démontrée sur cette gamme de températures et il n'est pas prouvé qu'elles puissent s'ajuster automatiquement en fonction de la température.

Un but de la présente invention consiste donc à réaliser un composant électro-optique peu coûteux comportant un détecteur et un élément parasite pour ce détecteur, tel qu'un laser ou tout autre élément, la longueur d'onde de fonctionnement de l'élément parasitaire étant inférieure à la longueur d'onde de réception du détecteur, et dans lequel la perturbation de 4,5 dB du détecteur par l'élément parasite (selon l'exemple de la figure 2), qui se produit lors de leur fonctionnement simultané, est considérablement réduite.

A cet effet, l'invention propose de réduire la portion active du détecteur apte à détecter un signal, alors que la lumière parasite illumine l'ensemble du détecteur.

L'invention concerne plus particulièrement un procédé de fabrication d'un composant électro-optique en semi-conducteur comprenant au moins deux structures optiquement actives dont au moins une est constituée par un détecteur, caractérisé en ce qu'il comprend une étape consistant à limiter la longueur de la portion active du(des) détecteur(s) apte à détecter un signal à une longueur d'onde donnée, la lumière parasite non guidée véhiculée dans le composant étant répartie sur l'ensemble du détecteur.

Selon un premier mode de réalisation, la limitation de la portion active du(des) détecteur(s) est réalisée par implantation de protons sur la portion restante du détecteur.

Selon un deuxième mode de réalisation, la limitation de la portion active du(des) détecteur(s) est réalisée par localisation du contact du détecteur sur cette portion.

Selon un troisième mode de réalisation, la limitation de la portion active du(des) détecteur(s) est réalisée par gravure de la portion restante, et croissance d'une couche passive sur cette dernière.

Selon un quatrième mode de réalisation, le détecteur est clivé de manière à le limiter à sa portion active.

La présente invention concerne également le composant obtenu par un tel procédé et plus particulièrement un composant électro-optique en semi-conducteur comprenant au moins deux structures optiquement actives dont au moins une est constituée par un détecteur, lesdites structures actives étant séparées par une section intermédiaire, caractérisé en ce que le(s) détecteur(s) comprend(nent) une première portion active apte à détecter un signal à une longueur d'onde donnée et une deuxième portion inactive faiblement sensible au signal à détecter et exposée à la lumière parasite non guidée véhiculée dans le composant.

Selon une première variante, la deuxième portion du(des) détecteur(s) est implantée de protons.

Selon une deuxième variante, le contact du détecteur est localisé sur la première portion.

Selon une troisième variante, chaque portion présente des couches d'épitaxie différentes, la couche active de la deuxième portion ayant été retirée par gravure et remplacée par une couche passive.

L'invention concerne également un composant électro-optique en semi-conducteur comprenant au moins deux structures optiquement actives dont au moins une est constituée par un détecteur, lesdites structures actives étant séparées par une section intermédiaire, caractérisé en ce que le détecteur est clivé de manière à le limiter à la longueur de la portion active apte à détecter un signal à une longueur d'onde donnée.

Selon une caractéristique, la longueur d'onde de réception du détecteur est supérieure à la (aux) longueur(s) d'onde de fonctionnement de la (des) autre(s) structure(s) parasite(s).

Selon une application, le composant selon l'invention constitue un émetteur-récepteur en ligne.

Selon une autre application, le composant selon l'invention constitue une barrette de récepteurs.

Le procédé selon l'invention permet d'obtenir un composant électro-optique multi-sections dans lequel la perturbation du détecteur par les autres éléments est considérablement diminuée.

En outre, les modes de réalisation décrits ne nécessitent pas la mise au point de nouveaux procédés de fabrication, et peuvent par conséquent être facilement et rapidement mis en oeuvre.

De plus, la limitation de la partie active du détecteur à sa partie avant limite le champ électrique sur la facette arrière clivée du composant, ce qui a pour conséquence directe de limiter les risques de détérioration du composant dus aux défauts sur la facette.

D'autres particularités et avantages de l'invention apparaîtront à la lecture de la description donnée à titre d'exemple illustratif et faite en référence aux figures annexées dans lesquelles :
- la figure 1 déjà décrite, est un schéma d'un émetteur-récepteur en ligne classique,
- la figure 2, déjà décrite, illustre des courbes permettant de mettre en évidence les pénalités de fonctionnement lors d'une modulation simultanée de l'émetteur et du récepteur du composant de la figure 1,
- la figure 3, est un schéma d'un composant optique selon un premier mode de réalisation de l'invention,
- la figure 4, est un schéma d'un composant optique selon un deuxième mode de réalisation de l'invention,
- les figures 5a à 5c, illustrent schématiquement les étapes de réalisation d'un composant optique selon un troisième mode de réalisation de l'invention,
- la figure 6a est un schéma d'un composant optique selon un quatrième mode de réalisation de l'invention,
- la figure 6b représente une vue de dessus de la figure 6a.

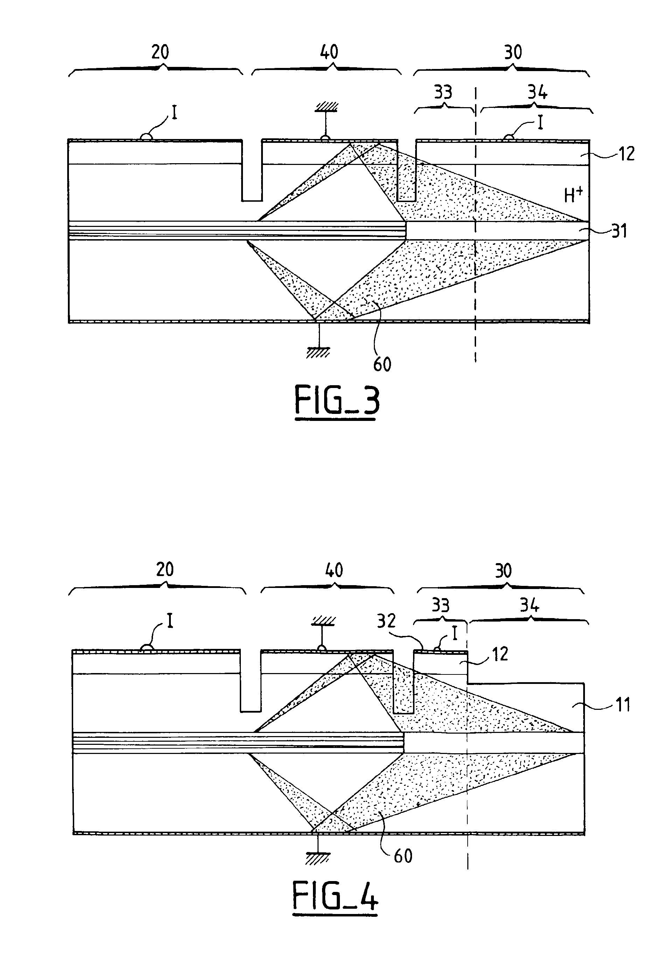

La figure 3 schématise un premier mode de réalisation d'un composant selon l'invention. Il schématise plus particulièrement un émetteur-récepteur en ligne. Mais l'invention ne se limite pas seulement aux émetteurs-récepteurs en ligne. Elle peut s'appliquer à tout composant opto-électronique intégré pour lequel il existe une diaphonie, c'est à dire à tout composant comprenant un élément parasite et un élément apte à détecter pour lequel les longueurs d'onde émises et reçues sont compatibles.

Par exemple, dans le cas d'une barrette de détecteurs, la lumière parasite provient de la fibre optique et est véhiculée dans tout le composant.

Dans l'exemple illustré, on considère un émetteur-récepteur. Les mêmes références sont utilisées pour désigner les mêmes éléments que dans l'émetteur-récepteur classique schématisé sur la figure 1. Le laser 20 émet à une longueur d'onde inférieure à la longueur d'onde de réception du détecteur 30. La longueur d'onde d'émission est par exemple égale à 1,3 µm alors que la longueur d'onde de réception est égale à 1,55 µm.

La lumière spontanée émise par le laser 20 et non guidée par le guide d'onde 21 est émise dans tout le volume du composant. De plus, une partie de la lumière stimulée est diffractée dans le composant du fait de la présence de défauts dans le guide d'onde 21. Toutes ces ondes lumineuses parasites émises à 1,3µm par le laser 20, dans toutes les directions, viennent perturber et éblouir le détecteur 30 qui ne peut plus détecter correctement la longueur d'onde à 1,55 µm.

Ces perturbations sont schématisées simplement par l'onde 60 sur la figure 3. Elles proviennent du dessus et du dessous des guides d'onde 21, 31 du composant émetteur-récepteur.

Ces perturbations entraînent une pénalité de 4,5 dB (selon l'exemple cité figure 2) lors d'un fonctionnement simultané du laser 30 et du détecteur 20.

Afin de minimiser l'impact de cette lumière parasite non guidée, l'invention propose de réduire la portion active 33 du détecteur 30.

En effet, il a été constaté que seuls les premiers micromètres du détecteur 30 absorbent environ 90 % du signal à détecter. Ainsi, par exemple, seul 30 µm d'un détecteur de 80 µm de long suffisent à une bonne détection d'un signal.

Or, la lumière parasite non guidée est répartie sur l'ensemble du guide d'onde 31 du détecteur 30. Ainsi, la portion arrière 34 du détecteur 30 peut recueillir plus de lumière parasite 60 que de signal.

C'est pourquoi la portion active 33 apte à détecter un signal est réduite, la lumière parasite non guidée étant répartie sur l'ensemble du détecteur 30.

Avantageusement, la longueur de la portion active du détecteur est fixée de manière à ce que ladite portion soit apte à détecter, par exemple, environ 90% du signal.

La lumière parasite couplée au guide d'onde 31 dans la portion active 33 est noyée dans le bruit du détecteur 30, le signal étant suffisamment fort pour être correctement détecté, alors que la lumière parasite couplée au guide d'onde 31 dans la portion restante 34 est plus intense que le signal qui a déjà été presque complètement détecté. Ainsi, la portion restante 34 du détecteur 30 détecte plus de lumière parasite 60 que de signal et nuit à la qualité du détecteur 30.

Plusieurs moyens sont envisageables pour limiter la portion active 33 du détecteur 30.

Une première méthode est illustrée sur la figure 3 et consiste à implanter des protons dans la portion arrière 34 du détecteur 30.

Cette implantation de protons H⁺, réalisée selon des techniques classiques, a pour effet de rendre la couche de gaine 11 de la portion arrière 34 isolante, c'est à dire incapable de collecter les porteurs jusqu'à la couche absorbante 12 pour être recueillis sur l'électrode métallique 32.

L'implantation de protons H⁺ peut également permettre de réduire la largeur de la portion active 33 pour des applications données.

Une deuxième méthode est illustrée sur la figure 4 et consiste à localiser la couche absorbante 12 et l'électrode métallique 32 uniquement sur la portion active 33 avant du détecteur 30.

A cet effet, la couche absorbante 12 et une partie de la couche conductrice 11 sont gravé sur la portion arrière 34 du détecteur 30. Ainsi, seul la portion avant 33 est apte à recueillir les porteurs. L'électrode métallique 32 sera alors réalisée uniquement sur la portion active 33 du détecteur 30.

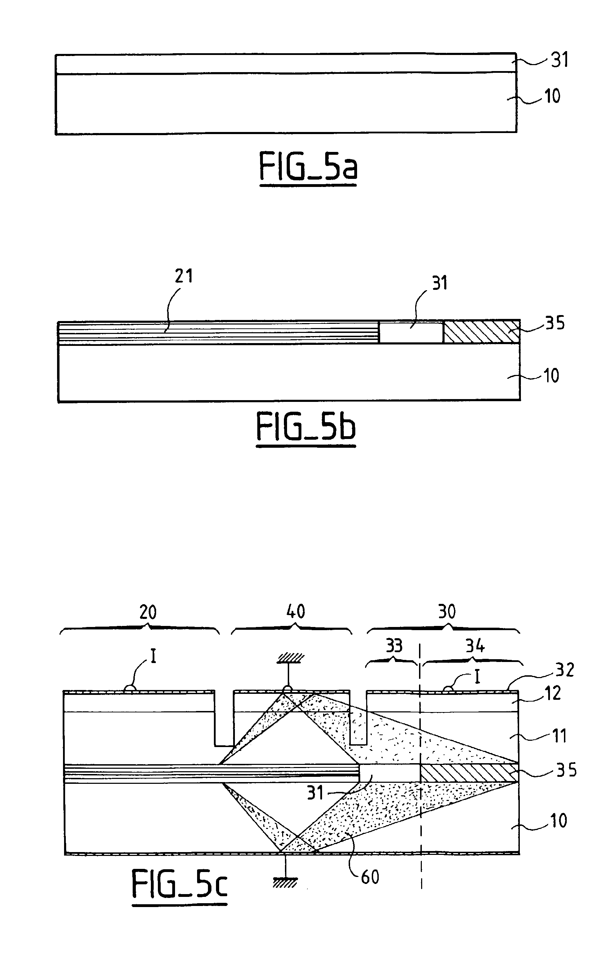

Une troisième méthode est illustrée sur les figures 5a à 5c et consiste à réaliser une gravure de la couche active 31 du détecteur 30 de manière à obtenir un guide d'onde actif 31 à l'avant 33 du détecteur 30 et une zone passive 35 à l'arrière 34 du détecteur 30.

A titre d'exemple, les schémas des figures 5a à 5c représentent des vues en coupe transversale dans le sens de la longueur du composant optique selon l'invention au cours des différentes étapes de cette méthode de localisation par gravure.

Cette méthode peut consister, par exemple, dans un premier temps, (figure 5a) à faire croître, sur un substrat 10, une première couche de matériau quaternaire 31 apte à jouer le rôle de guide d'onde actif du détecteur 30.

Une gravure locale (figure 5b) du guide d'ondes 31 est ensuite pratiquée, selon un procédé de gravure classique, afin de limiter le guide actif 31 à une zone active 33. Une autre étape d'épitaxie permet alors de faire croître le guide d'ondes de l'autre élément 21, ainsi qu'une zone passive 35 sur l'arrière 34 du détecteur 30. La structure de la zone passive 35 est différente de celle du guide actif 31.

Par exemple, la zone passive 35 peut être un guide passif, ou être de même nature que la couche de gaine 11, ou d'une tout autre composition.

Ces couches 21, 31 et 35 sont alors enterrées dans une couche de gaine en InP 11, qui constitue la couche conductrice précédemment décrit, et une couche absorbante 12. Une électrode 32 est réalisée sur le détecteur 30, sans être forcément limitée à la portion active 33 car aucun porteur ne proviendra de la portion arrière 34 du détecteur 30.

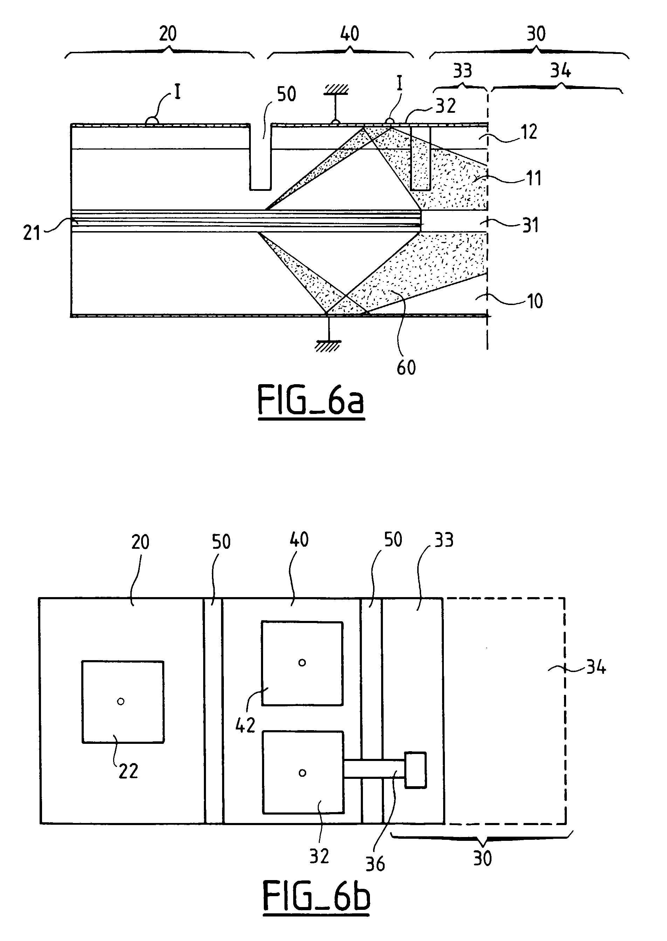

Une quatrième méthode est illustrée sur les figures 6a et 6b et consiste à cliver le détecteur 30 afin de le limiter à la portion active 33.

La figure 6b est une vue de dessus du composant optique de la figure 6a.

Le détecteur 30 étant clivé et réduit à la portion active 33, cette dernière est trop étroite pour recevoir une électrode métallique 32 dont les dimensions sont conditionnées par la réalisation d'une connexion filaire. Cette dernière est en effet généralement réalisée par thermocompression d'un fil d'or sur l'électrode métallique 32, cette soudure étant difficilement réalisable sur une électrode de 30 µm de côté.

Il est par conséquent nécessaire de réaliser un report de métallisation pour l'électrode métallique 32, c'est à dire de réaliser cette électrode 32 sur la section centrale 40 et d'établir le contact avec la portion active 33 du détecteur 30 par un pont conducteur 36.

## Revendications

1. Procédé de fabrication d'un composant électro-optique en semi-conducteur comprenant au moins deux structures optiquement actives (20, 30) dont au moins une est constituée par un détecteur (30), caractérisé en ce qu'il comprend une étape consistant à limiter la longueur de la portion active (33) du(des) détecteur(s) apte à détecter un signal à une longueur d'onde donnée, la lumière parasite non guidée véhiculée dans le composant étant répartie sur l'ensemble du(des) détecteur(s) (30).

2. Procédé selon la revendication 1, caractérisé en ce que la limitation de la portion active (33) du(des) détecteur(s) (30) est réalisée par implantation de protons sur la portion restante (34) du détecteur (30).

3. Procédé selon la revendication 1, caractérisé en ce que la limitation de la portion active (33) du(des) détecteur(s) (30) est réalisée par localisation du contact (13) du détecteur (30) sur cette portion (33).

4. Procédé selon la revendication 1, caractérisé en ce que la limitation de la portion active (33) du(des) détecteur(s) (30) est réalisée par gravure de la portion restante (34) et croissance d'une couche passive (35) sur cette dernière (34).

5. Procédé selon la revendication 1, caractérisé en ce que le détecteur (30) est clivé de manière à le limiter à sa portion active (33).

6. Composant électro-optique en semi-conducteur comprenant au moins deux structures optiquement actives (20, 30) dont au moins une est constituée par un détecteur (30), lesdites structures actives (20, 30) étant séparées par une section intermédiaire (40), caractérisé en ce que le(s) détecteur(s) (30) comprend(nent) une première portion active (33) apte à détecter un signal à une longueur d'onde donnée et une deuxième portion inactive (34) faiblement sensible au signal à détecter et exposée à la lumière parasite non guidée véhiculée dans le composant.

7. Composant selon la revendication 6, caractérisé en ce que la deuxième portion (34) du(des) détecteur(s) (30) est implantée de protons.

8. Composant selon la revendication 6, caractérisé en ce que le contact (13) du détecteur (30) est localisé sur la première portion (33).

9. Composant selon la revendication 6, caractérisé en ce que chaque portion (33, 34) présente des couches d'épitaxie différentes (4), la première portion (33) comprenant une couche active (31) et la deuxième portion (34) comprenant une zone passive (35).

10. Composant électro-optique en semi-conducteur comprenant au moins deux structures optiquement actives (20, 30) dont au moins une est constituée par un détecteur (30), lesdites structures actives (20, 30) étant séparées par une section intermédiaire (40), caractérisé en ce que le détecteur (30) est clivé de manière à le limiter à la longueur de la portion active (33) apte à détecter un signal à une longueur d'onde donnée.

11. Composant selon l'une quelconque des revendications 6 à 10, caractérisé en ce que la longueur d'onde de réception du détecteur (30) est supérieure à la (aux) longueur(s) d'onde de fonctionnement de la (des) autre(s) structure(s) optiquement active(s) (20).

12. Composant selon l'une quelconque des revendications 6 à 11, caractérisé en ce qu'il constitue un émetteur-récepteur en ligne.

13. Composant selon l'une quelconque des revendications 6 à 11, caractérisé en ce qu'il constitue une barrette de récepteurs.
